# EUROPÄISCHE PATENTANMELDUNG

(11) **EP 0 539 650 A1**
(43) Veröffentlichungstag der Anmeldung: **05.05.1993**
(21) Anmeldenummer: 92106387.1
(22) Anmeldetag: 14.04.1992
(51) Int. Cl.: H01J 37/34

(54) **Zerstäubungskathode**

(30) Priorität: 31.10.1991 DE 4135939
(71) Anmelder: LEYBOLD AKTIENGESELLSCHAFT, D-63450 Hanau (DE)
(72) Erfinder: Sichmann, Eggo, W-6460 Gelnhausen (DE)
(74) Vertreter: Sartorius, Peter, Dipl.-Ing. Patentanwalt

(57) **Zusammenfassung**

**Die Erfindung bezieht sich auf** eine Zerstäubungskathode für die Beschichtung von Substraten in Kathodenzerstäubungsanlagen mit einem Kathodengrundkörper 5, einem darauf angeordneten Target 9 aus amagnetischem Material mit mindestens einer ebenen Zerstäubungsfläche 9a, einem Magnetsystem 7 mit beiderseits der Targetränder liegenden Polflächen 7c, 7d entgegengesetzter Polung zur Erzeugung eines in sich geschlossenen, die Zerstäubungsfläche 9a übergreifenden Tunnels aus Magnetfeldlinien, wobei die das Target 9 umgebenden Polschuhe 23, 24 zumindest bis zur äußeren Begrenzung des Targets 9 reichen bzw. diese teilweise überlappen.

## Beschreibung

Die Erfindung bezieht sich auf eine Zerstäubungskathode für die Beschichtung von Substraten in Kathodenzerstäubungsanlagen mit einem Kathodengrundkörper, einem darauf angeordneten Target aus amagnetischem Material mit mindestens einer ebenen Zerstäubungsfläche, einem Magnetsystem mit beiderseits der Targetränder liegenden Polflächen entgegengesetzter Polung zur Erzeugung eines in sich geschlossenen, die Zerstäubungsfläche übergreifenden Tunnels aus Magnetfeldlinien.

**Es ist bereits aus der DE 22 43 708 A1** eine Stabkathode mit einem zylindrischen Target bekannt, das an beiden Enden flanschförmige Vorsprünge aus Targetmaterial aufweist. Durch eine sorgfältige Abstimmung des zugehörigen Magnetsystems läßt sich erreichen, daß der Raum um den Zylinder und zwischen den flanschförmigen Vorsprüngen von zur Zylinderachse nahezu parallel verlaufenden Magnetfeldlinien durchsetzt wird. Zwar wird mit einem solchen System die Gleichförmigkeit der Targeterosion ganz wesentlich verbessert, bezogen auf die Niederschlagsrate tritt jedoch nur eine unwesentliche Verbesserung ein. Dies liegt daran, daß das Material des Targets nach allen Richtungen, sozusagen "rundum", abgestäubt wird, was nur dann sinnvoll ist, wenn auch die zu beschichtenden Substrate um die Stabkathode herum in möglichst enger Packungsdichte angeordnet sind. Das Prinzip der gleichförmigeren Targeterosion führt jedoch dann nicht zum Erfolg, wenn an einer Seite der Pfosten-Kathode großflächige Substrate auf einem platten- oder rahmenförmigen Träger angeordnet sind. Auf derartige Substrate trifft stets nur ein Bruchteil des zerstäubten Targetmaterials auf. Nun geht es aber weniger darum, die Zerstäubungsrate zu erhöhen, sondern vorrangig um die Erhöhung der Niederschlagsrate auf den Substraten.

Bei einer anderen allgemein bekannten Pfosten-Kathode mit den beiderseitigen Flanschen am Target muß die Targetlänge und damit der Abstand der Flansche stets der maximalen Beschichtungsbreite der Substrate angepaßt werden. Dies liegt daran, daß die Bewegungsrichtung der Substrate senkrecht zur Längsachse der Pfosten-Kathode verlaufen muß. Bei einem 3 m breiten Substrat (Fensterscheibe) müßten mithin die Flansche einen Abstand von mindestens 3,20 m aufweisen, um die Inhomogenität an den beiderseitigen Kathodenenden nicht wirksam werden zu lassen. Die für die Erzielung einer gleichmäßigen Schichtdicke über die gesamte Substratbreite erforderliche gleichförmige Verteilung der Zerstäubungsrate und damit des Magnetfeldes ist bei solchen Kathodenlängen ein praktisch unlösbares Problem.

**Durch die DE-OS 34 11 536 ist eine Zerstäubungskathode bekannt,** bei der die Polflächen des Magnetsystems seitlich neben den inneren und äußeren Begrenzungsflächen des plattenförmigen Targets liegen, das in der Draufsicht ringförmig (kreisringförmig, oval, rahmenförmigrechteckig) ist. Dadurch wird die Krümmung der Magnetfeldlinien relativ zu den Targetabmessungen, die von den Feldlinien überspannt werden müssen, deutlich verringert, wodurch sich die Breite des Erosionsgrabens entsprechend vergrößert, so daß eine wesentlich bessere Materialausnutzung die Folge ist.

Ferner ist eine Zerstäubungskathode für die Beschichtung von Substraten in Kathodenzerstäubungsanlagen bekannt, die mit einem eine Vertiefung aufweisenden Kathodengrundkörper und einem darauf angeordneten Target aus amagnetischem Material mit mindestens einer ebenen Zerstäubungsfläche ausgestattet ist. In dem zugehörigen Magnetsystem ist beiderseits der Targetränder eine Abschirmung vorgesehen (DE 35 27 626 A1). Eine derartige Abschirmung ist aufwendig und teuer.

**Hier will die Erfindung Abhilfe schaffen. Gelöst wird die Aufgabe erfindungsgemäß dadurch,** daß die das Target umgebenden Polschuhe zumindest bis zur äußeren Begrenzung des Targets reichen. Hierdurch wird es mit einfachen baulichen Mitteln auf kostengünstige Weise möglich, die Sputterrate an den Polschuhen wesentlich herabzusetzen oder auch vollständig zu vermeiden. Ferner kann durch die vorteilhafte Ausgestaltung der Polschuhe auf die bekannte aufwendige Abschirmung verzichtet werden. Die vorteilhafte Ausgestaltung der Polschuhe hat unter anderem zwei Komponenten: Einmal wird durch die auf die Elektronen einwirkende, elektrostatische Kraft erreicht, daß die Elektronen senkrecht aus der Targetoberfläche austreten und durch die Polschuhe, die ebenfalls negativ aufgeladen sind, zur Targetmitte hin abgelenkt werden, und ferner verhindern die Polschuhverlängerungen auf kostengünstige Weise eine seitliche Abwanderung der Elektronen aus der Targetoberfläche.

Das hat den Vorteil, daß sich ein Erosionsprofil in dem Target ausbildet, das flach verläuft, so daß eine gleichmäßige Schichtdickenverteilung auf dem Substrat erfolgt. Ferner wird der Targetwirkungsgrad wesentlich verbessert bzw. die Standzeit des Targets vergrößert, da tiefe Gräben im Target beim Zerstäubungsvorgang vermieden werden.

Durch die erfindungsgemäße Ausgestaltung der Polschuhe kann in vorteilhafter Weise die Targetoberfläche flach ohne seitliche Flanken ausgebildet werden, so daß die Bearbeitungskosten zur Herstellung des Targets wesentlich herabgesetzt werden können. Ferner kann im Bereich der Targetoberfläche ein mit Dunkelraumabstand angeordneter, innerer und äußerer Ring, der normalerweise notwendig ist, eingespart werden.

Hierzu ist es vorteilhaft, daß die stirnseitigen Enden der Polschuhe als Verlängerungsteile ausgebildet sind.

Ferner ist es vorteilhaft, daß die Verlängerungsteile ringförmig ausgebildet sind.

Eine zusätzliche Möglichkeit ist, gemäß einer Weiterbildung der erfindungsgemäßen Vorrichtung, daß die ringförmigen Verlängerungsteile in etwa die gleiche Stärke aufweisen wie die Polschuhe.

In weiterer Ausgestaltung der Erfindung ist es vorteilhaft, daß die Verlängerungsteile auf dem gleichen Durchmesser wie die Polschuhe angeordnet sind.

Gemäß einer bevorzugten Ausführungsform der erfindungsgemäßen Lösung ist schließlich vorgesehen, daß die auf die Polschuhe aufgesetzten, ringförmigen Verlängerungen als ferromagnetisches System ausgebildet sind und ein wahlfreies oder negatives Potential aufweisen.

Von besonderer Bedeutung ist für die vorliegende Erfindung, daß die auf die Polschuhe aufgesetzte, ringförmige Verlängerung über eine elektrische Leitung mit einer Spannungsversorgung und/oder einer Stromregelung verbunden ist. Hierdurch wird, je nach Einstellung des Potentials, eine unterschiedlich starke Absputterrate an den Polschuhen bewirkt und, je nach Beschaffenheit, bis auf etwa Null herabgesetzt. Je nach Ausbildung des Magnetfeldes ist das Potential an den Polschuhen geringer als am Target.

Im Zusammenhang mit der erfindungsgemäßen Ausbildung und Anordnung ist es von Vorteil, daß zwischen den Polschuhen und dem Target eine Spannung zwischen 50 V und 250 V anliegt.

Vorteilhaft ist es ferner, daß die zwischen den Polschuhen und dem Target anliegende Spannung regelbar ist, wobei der I-Sollwert gleich oder annähernd Null ist. Wird der I-Sollwert annähernd auf Null eingestellt bzw. sichergestellt, daß kein Strom fließt, so läßt sich die Sputterrate an den Polschuhen auf ein Minimum reduzieren, so daß in vorteilhafter Weise nur an der freiliegenden Targetoberfläche ein Sputtern auftritt. Hierdurch wird es auch möglich, ferromagnetisches Material zu beschichten.

Hierzu ist es vorteilhaft, daß die Verlängerungsteile der Polschuhe mit Bezug auf das Target unterschiedlich große Durchmesser aufweisen, um auf diese Weise die Schichtdicke zu beeinflussen oder unterschiedliche Flächen mit dem gleichen Targetaufbau zu beschichten.

Vorteilhaft ist es außerdem, daß die negative Spannung an den Polschuhen zwischen Kathodenpotential und Anodenpotential durch einen elektrischen Spannungsteiler anstelle einer zusätzlichen Stromversorgung erzeugt und das negative Potential der Polschuhe nach dem Zünden des Plasmas weggenommen werden kann.

**Weitere Vorteile und Einzelheiten der Erfindung sind in den Patentansprüchen** und in der Beschreibung ausgeführt und in den Figuren dargestellt, wobei bemerkt wird, daß alle Einzelmerkmale und alle Kombinationen von Einzelmerkmalen erfindungswesentlich sind.

In den Figuren ist die Erfindung an einer Ausführungsform beispielsweise dargestellt, ohne auf diese Ausführungsform beschränkt zu sein. Es zeigt:
- Figur 1: einen Kathodengrundkörper, der aus einem ferromagnetischen Werkstoff besteht und gleichzeitig das Magnetjoch für das Magnetsystem bildet, wobei die Targetzerstäubungsfläche eben ausgebildet ist und die Polschuhe mit einer Polschuhverlängerung versehen sind,
- Figur 2: ein zweites Ausführungsbeispiel einer Zerstäubungskathode, die in jedes Target, ähnlich wie in Figur 1, einbaubar ist, wobei das Target mit einer Vertiefung versehen ist.

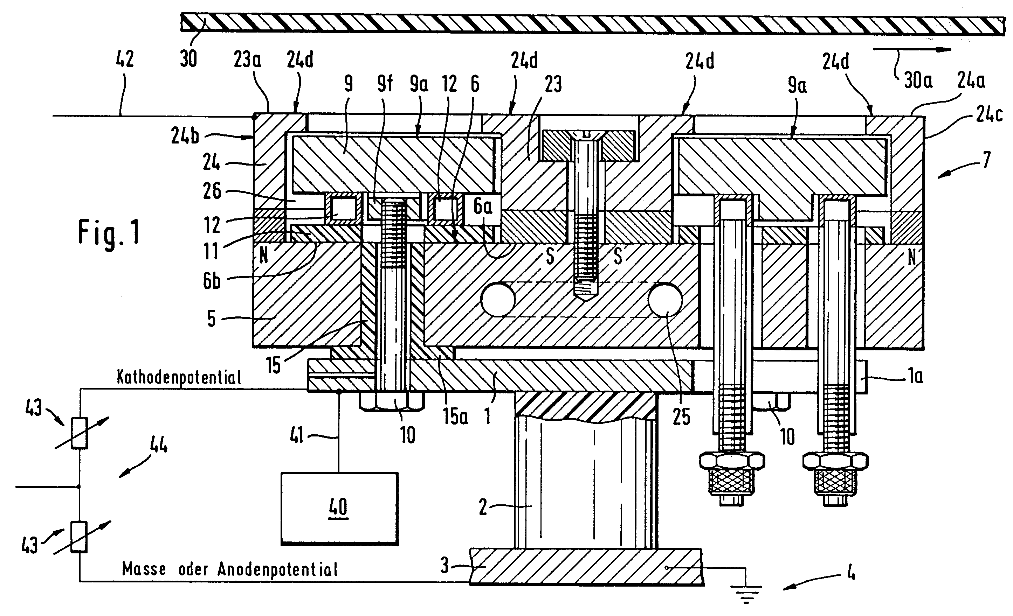

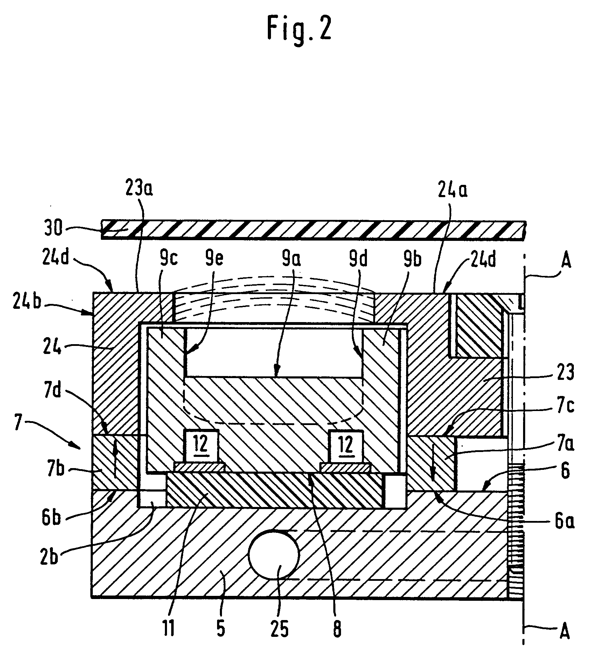

In den Figuren 1 und 2 ist ein Kathodengrundkörper 5 dargestellt, der aus einem ferromagnetischen Werkstoff besteht und gleichzeitig das Magnetjoch für das nachfolgend näher beschriebene Magnetsystem bildet. Der Kathodengrundkörper 5 besitzt eine obere Ebene 6, in der ringförmig geschlossene Auflageflächen 6a und 6b für die Permanentmagnete eines Magnetsystems 7 liegen. Es handelt sich um einen inneren Ringmagneten 7a und eine geschlossene, äußere Reihe von Stabmagneten 7b, die sämtlich, in Bezug auf die Achse A-A des Systems, axial magnetisiert sind und zwar derart, daß die Polungsrichtung des inneren Ringmagneten 7a umgekehrt zu der der äußeren Stabmagnete 7b verläuft. Die Pollage ist in Figur 1 eingezeichnet. Die Magnete besitzen auf der dem Kathodengrundkörper 5 abgekehrten Seite Polflächen 7c und 7d, die in einer gemeinsamen Ebene liegen.

Auf den Polflächen 7c und 7d liegen wiederum weichmagnetische Polschuhe 23 und 24 auf, wobei die Anordnung derart getroffen ist, daß zwischen den Permanentmagneten und den Polschuhen 23, 24 ein hohlzylindrischer Raum 26 gebildet wird, der um die Achse A-A herum geschlossen verläuft und nach oben hin offen ist.

Zwischen den Auflageflächen 6a und 6b (Fig. 2) liegt eine ringförmig geschlossene Auflagefläche 8, die den Boden des hohlzylindrischen Raums 26 bildet. Auf dieser Auflagefläche 8 ruht ein Isolierkörper 11, der zur Abstützung eines Targets 9 dient. Dieses Target 9 bildet das Ausgangsmaterial für die zu erzeugenden Schichten, die auf einem Substrat bzw. einer Compact Disk 30 niedergeschlagen werden sollen, die hier nur andeutungsweise dargestellt ist. Das Target 9 besitzt eine ebene Zerstäubungsfläche 9a, die beiderseits von zwei in sich geschlossenen, konzentrisch ineinander liegenden Vorsprüngen 9b und 9c begrenzt ist, die aus dem gleichen amagnetischen Werkstoff bestehen wie der übrige Teil des Targets 9.

Wie aus Figur 1 hervorgeht, kann das Target 9 mit der planen Zerstäubungsfläche 9a versehen oder gemäß Figur 2 von den Vorsprüngen 9b, 9c umgeben sein, wobei die Zerstäubungsfläche 9a mit einer konzentrischen Verwerfung ausgestattet sein kann und die Polschuhe mit einer ähnlichen Polschuhverlängerung bzw. Verlängerungsteilen 24b wie in Fig. 1 ausgestattet sind. Die Vorsprünge 9b und 9c, gemäß Figur 2, besitzen aufeinander zu gerichtete Wandflächen 9d und 9e, deren Enden senkrecht zur Zerstäubungsfläche 9a verlaufen. Im vorliegenden Fall handelt es sich um Zylinderflächen.

Die Polschuhe 23 und 24 besitzen im Bereich ihrer Stirnseiten sowie ihrer, den hohlzylindrischen Raum 26 begrenzenden Wandflächen Polflächen 23a und 24a, wobei aus Platzgründen nur die stirnseitigen Teile der Polflächen beziffert sind. Die Polflächen 23a und 24a sind beiderseits der Vorsprünge 9b und 9c und der zwischen ihnen liegenden Zerstäubungsfläche 9a soweit in Zerstäubungsrichtung über die Ebene der Zerstäubungsfläche 9a vorgezogen, daß ein wesentlicher Teil der Magnetfeldlinien in meist senkrechter Richtung aus der Wandfläche 9e des Vorsprungs 9c austritt und nach Überqueren der Zerstäubungsfläche 9a in die gegenüberliegende Wandfläche 9d des Vorsprungs 9b in ebenfalls meist senkrechter Richtung wieder eintritt. Dadurch werden die oben beschriebenen vorteilhaften Wirkungen bezüglich einer äußerst gleichmäßigen Erosion der Zerstäubungsfläche 9a sowie einer hohen Zerstäubungsrate erreicht. Der Zerstäubungsvorgang wird zweckmäßig dann abgebrochen, wenn die ursprüngliche Zerstäubungsfläche 9a an der darunter liegenden, gestrichelten Linie angelangt ist. Die zu den Polflächen 23a, 24a parallel verlaufenden magnetischen Feldlinien sind oberhalb der Zerstäubungsfläche 9a gestrichelt dargestellt. Der Verlauf der Feldlinien hat den Vorteil, daß sich ein Erosionsprofil in dem Target 9 ausbildet, das flach verläuft, so daß eine gleichmäßige Schichtdickenverteilung auf dem Substrat 30 erfolgt. Ferner wir dadurch der Targetwirkungsgrad wesentlich verbessert.

Um jedoch eim Plasma zünden zu können, müssen die Elektronen in einer Umlaufbahn an der Targetoberfläche gehalten bzw. fokussiert werden. Dies wird in vorteilhafter Weise durch den Vertikalanteil des Magnetfeldes erreicht. Hierbei ist zu beachten, daß sich Magnetbeschichtungsquellen dadurch auszeichnen, daß ein meist konstantes Magnetfeld im Bereich der Targetoberfläche erzeugt wird. Dieses Magnetfeld hat die Aufgabe, wie bereits erwähnt, Elektronen im Bereich der Targetoberfläche zu konzentrieren, wobei die Elektronen senkrecht zur Richtung der Feldlinien abgelenkt werden. Dadurch ist eine Fokussierung der Elektronen bei einem weitgehend parallel zur Targetoberfläche ausgebildeten Magnetfeld zur Targetmitte hin möglich.

Um das Abwandern der Elektronen zur Seite zu vermeiden, sind in vorteilhafter Weise die Verlängerungsteile an den Polschuhen 24b vorgesehen, die um die Polfläche 24a herumgezogen sein können. Durch die elektrischen und geometrischen Einflüsse werden die Elektronen am seitlichen Verlassen der Targetoberfläche bzw. der Zerstäubungsfläche 9a gehindert. Der elektronische Einfluß wird dadurch erreicht, daß elektrisch leitende Bleche bzw. Verlängerungsteile 24b zumindest auf den zu zerstäubenden Bereich des Targets 9 hochgezogen werden. Diese Verlängerungsteile 24b können über eine elektrische Leitung 42 mit dem Kathodenpotential bzw. dem Target 9 verbunden sein. In die elektrische Leitung 42 kann ein Widerstand 43 bzw. eine Stromversorgungseinheit 40 geschaltet werden. Der Widerstand 43 ist erheblich höher als die Plasmaimpedanz. Zur Erweiterung kann die Stromversorgungseinheit 40 mit einer Stromregelung zwischen Kathode bzw. Target 9 und den Targetblechen bzw. den Verlängerungsteilen der Polschuhe 24b ausgestattet sein, um den elektrischen Einfluß variieren zu können. Die Verlängerungsteile 24b können einteilig oder lösbar mit dem übrigen Teil des Polschuhes 24 verbunden sein.

Je nach Größe des Widerstands oder der Einstellung des Stroms an der Spannungsversorgung, kann der Abtrag des Blechmaterials der Verlängerungsteile 24b verändert bzw. nahezu vollständig vermieden werden.

Werden die Bleche aus ferromagnetischem Material als verlängerte Polschuhe 24b ausgebildet (vergl. Figur 1 und 2), wird dadurch automatisch ein weitgehend paralleles Magnetfeld erzeugt, das einen gleichmäßigen Abtrag des zu zerstäubenden Materials fördert.

Die Polschuhe 23, 24 bestehen aus einem vertikalen Teil 24c und dem horizontalen Teil 24d, die die Elektronen fokussieren.

Wie aus den Figuren 1 und 2 hervorgeht, sind die Polschuhe 23 und 24 an ihren stirnseitigen Enden zumindest bis zur Targetoberfläche oder Zerstäubungsfläche 9a verlängert.

Um die bei der Zerstäubung in das Target 9 eintretende Wärmemenge abführen zu können, sind an der Unterseite des Targets 9 Kühlkanäle 12 angeordnet, die über einen großen Teil ihrer Länge konzentrisch verlaufen und durch Ringscheiben 12b verschlossen sind. Auch der Kathodengrundkörper 5 ist in analoger Weise mit einem Kühlkanal 25 ausgestattet.

Figur 2 zeigt eine vollständige Zerstäubungskathode, in die im Prinzip jedes Target aus Figur 1 einbaubar ist.

Hier ist eine Stromzuführungsplatte 1 (vergl. auch Figur 1) dargestellt, die über einen Stützisolator 2 mit einer Vakuumkammer 3 verbunden ist, die ihrerseits an Masse 4 liegt. Die Stromzuführungsplatte 1 ist über eine Leitung 41 mit der Stromversorgungseinheit 40 verbunden, die für das Zerstäuben von metallischen bzw. elektrisch leitfähigen Targets als Gleichspannungsquelle ausgebildet ist.

Mit der Stromzuführungsplatte 1 ist der Kathodengrundkörper 5 isoliert aber fest verbunden, und zwar unter Zwischenschaltung von Isolierkörpern 15 mit Kragen 15a, von denen mehrere auf den Umfang verteilt sind, jedoch nur einer im Schnitt gezeigt ist. Das Target 9 entspricht im vorliegenden Fall weitgehend dem nach Figur 1, wobei lediglich die Kühlkanäle 12 durch ein bifilar gewickeltes Rohr mit quadratischem Querschnitt gebildet werden, das zwischen dem Target 9 und dem Isolierkörper 12 durch mehrere auf den Umfang verteilte Zugschrauben 10 eingespannt wird, um einen guten Wärmeübergang zu gewährleisten.

Die Zugschrauben 10 durchdringen die Stromzuführungsplatte 1, unter Zwischenschaltung der Isolierkörper 15 auch den Kathodengrundkörper 5 und stellen die elektrische Verbindung mit dem Target 9 her. Zu diesem Zweck ist das Target 9 an seiner Unterseite mit einer umlaufenden Rippe 9f versehen, die Gewindebohrungen aufweist, die in die Zugschrauben 10 eingreifen.

Die Enden 12b und 12c der Zugschrauben 10 sind in ausreichenden Isolierabständen durch Bohrungen im Kathodenkörper 5 sowie durch eine radiale Ausnehmung 1a in der Stromzuführungsplatte 1 hindurchgeführt.

Es ist durch entsprechende Wahl der Dicke des Isolierkörpers 11 und/oder der axialen Länge der Polschuhe 23 und 24 möglich, die Zerstäubungsfläche 9a in eine bestimmte räumliche Lage zu den Polflächen 23a und 24a zu bringen (rechte Seite von Fig. 2).

Es ist erkennbar, daß wegen der Isolierkörper 11 und 15 die Stromzuführungsplatte 1 und das Target 9 sowohl gegenüber dem Kathodengrundkörper 5 mit dem Magnetsystem 7 als auch gegenüber der Vakuumkammer 3 bzw. der Masse 4 elektrisch isoliert sind. Während das Target 9 über die Stromzuführungsplatte 1 auf ein definiertes negatives Potential gebracht werden kann und auch die Masse 4 ein definiertes Potential (O-Potential) darstellt, ist der Kathodenkörper 5 mit dem Magnetsystem 7 bzw. dem Teil 24d elektrisch frei und kann sich auf ein durch die Betriebsbedingungen vorgegebenes Zwischenpotential einstellen, bei dessen Erreichen sich innerhalb kürzester Zeit selbständig der Effekt einstellt, daß eine Zerstäubung des Teils 24d und damit des Magnetsystems 7 unterbleibt. Die Stromzuführungsplatte 1 kann mit einer (nicht dargestellten) Dunkelraumabschirmung versehen sein, so daß auch eine Zerstäubung der Stromzuführungsplatte nach der Rückseite hin ausgeschaltet wird.

Die Erfindung ist keineswegs auf eine rotationssymmetrische Anordnung beschränkt. Der Querschnitt, gemäß Figur 2 (ein Axialschnitt), steht auch stellvertretend für einen Querschnitt durch eine sogenannte, in der Zeichnung nicht dargestellte Langkathode. Man muß sich die Zerstäubungskathode dann lediglich, entsprechend zur Zeichenebene, in senkrechter Richtung verlängert denken. Derartige Kathoden können bei einer Breite von etwa 30 bis 40 cm ohne weiteres Baulängen von etwa 4 m erreichen. Auch sind alle Zwischenformen von der Kreis- bis zur Rechteckform denkbar. Das Substrat 30 kann dann bei seiner Relativverschiebung gegenüber der Kathode in Richtung eines Pfeils 30a äußerst gleichförmig beschichtet sein.

Nach einer weiteren Ausführungsform ist es auch möglich, daß die negative Spannung an den Polschuhen 23, 24 zwischen Kathodenpotential und Anodenpotential durch einen elektrischen Spannungsteiler 44 anstelle einer zusätzlichen Stromversorgung erzeugt und das negative Potential der Polschuhe 23, 24 nach dem Zünden des Plasmas weggenommen werden kann. Dies stellt eine Zündhilfe für die Kathode (Target) 9 dar.

### Bezugszeichenliste

- 1: Stromzuführungsplatte
- 1a: Ausnehmung
- 2: Stützisolator
- 3: Vakuumkammer
- 4: Masse
- 5: Kathodengrundkörper; Magnetjoch
- 6: obere Ebene Kathodengrundkörper
- 6a: Auflagefläche
- 6b: Auflagefläche
- 7: Magnetsystem
- 7a: Ringmagnet
- 7b: Stabmagnet
- 7c: Polfläche
- 7d: Polfläche
- 8: Auflagefläche
- 9: Target (Kathode)
- 9a: Zerstäubungsfläche
- 9b: Vorsprung
- 9c: Vorsprung
- 9d: Wandfläche
- 9e: Wandfläche
- 9f: Rippe
- 10: Zugschraube
- 1: 1 Isolierkörper
- 12: Kühlkanal
- 12b: Ringscheibe
- 12c: Ringscheibe
- 15: Isolierkörper
- 15a: Kragen
- 23: Polschuh
- 23a: Polfläche
- 24: Polschuh
- 24a: Polfläche
- 24b: Blech oder Verlängerungsteil des Polschuhes
- 24c: vertikaler Teil
- 24d: horizontaler Teil
- 25: Kühlkanal
- 26: hohlzylindrischer Raum
- 30: Substrat, Compact Disk (Anode)
- 30a: Pfeil
- 40: Stromversorgungseinheit mit Stromregelung
- 41: Leitung
- 42: Leitung
- 43: Widerstand
- 44: Spannungsteiler

## Patentansprüche

1. Zerstäubungskathode für die Beschichtung von Substraten in Kathodenzerstäubungsanlagen mit einem Kathodengrundkörper, einem darauf angeordneten Target (9) aus amagnetischem Material mit mindestens einer ebenen Zerstäubungsfläche (9a), einem Magnetsystem mit beiderseits der Targetränder liegenden Polflächen entgegengesetzter Polung zur Erzeugung eines in sich geschlossenen, die Zerstäubungsfläche übergreifenden Tunnels aus Magnetfeldlinien, **dadurch gekennzeichnet,** daß die das Target umgebenden Polschuhe (23, 24) zumindest bis zur äußeren Begrenzung des Targets (9) reichen.

2. Zerstäubungskathode nach Anspruch 1, **dadurch gekennzeichnet,** daß die stirnseitigen Enden der Polschuhe (23, 24) als Verlängerungsteile (24b) ausgebildet sind bzw. Verlängerungsteile aufweisen.

3. Zerstäubungskathode nach Anspruch 1 oder 2, **dadurch gekennzeichnet,** daß die Verlängerungsteile (24b) ringförmig ausgebildet sind.

4. Zerstäubungskathode nach Anspruch 1, **dadurch gekennzeichnet,** daß die ringförmigen Verlängerungsteile (24b) in etwa die gleiche Stärke wie die Polschuhe (23, 24) aufweisen.

5. Zerstäubungskathode nach einem oder mehreren der vorhergehenden Ansprüche, **dadurch gekennzeichnet,** daß die Verlängerungsteile (24b) auf dem gleichen Durchmesser wie die Polschuhe (23, 24) verlaufen.

6. Zerstäubungskathode nach einem oder mehreren der vorhergehenden Ansprüche, **dadurch gekennzeichnet,** daß die auf die Polschuhe (23, 24) aufgesetzten, ringförmigen Verlängerungen (24b) als ferromagnetisches System ausgebildet sind und ein wahlfreies Potential aufweisen.

7. Zerstäubungskathode nach einem oder mehreren der vorhergehenden Ansprüche, **dadurch gekennzeichnet,** daß die auf die Polschuhe (23, 24) aufgesetzten, ringförmigen Verlängerungen (24b) als ferromagnetisches System ausgebildet sind und ein negatives Potential aufweisen.

8. Zerstäubungskathode nach einem oder mehreren der vorhergehenden Ansprüche, **dadurch gekennzeichnet,** daß die auf die Polschuhe (23, 24) aufgesetzten ringförmigen Verlängerungen (24b) über eine elektrische Leitung (42) mit einer Stromversorgungseinheit mit Stromregelung (40) verbunden ist.

9. Zerstäubungskathode nach einem oder mehreren der vorhergehenden Ansprüche, **dadurch gekennzeichnet,** daß das Potential an den Polschuhen (23, 24) geringer ist als am Target (9).

10. Zerstäubungskathode nach einem oder mehreren der vorhergehenden Ansprüche, **dadurch gekennzeichnet,** daß zwischen den Polschuhen (23, 24) und dem Target (9) eine Spannung zwischen 50 V und 250 V anliegt.

11. Zerstäubungskathode nach einem oder mehreren der vorhergehenden Ansprüche, **dadurch gekennzeichnet,** daß die zwischen den Polschuhen (23, 24) und dem Target (9) anliegende Spannung regelbar ist, wobei der I-Sollwert gleich oder annähernd Null ist.

12. Zerstäubungskathode nach einem oder mehreren der vorhergehenden Ansprüche, **dadurch gekennzeichnet,** daß die Verlängerungsteile der Polschuhe (24b) mit Bezug auf das Target (9) unterschiedlich große Durchmesser aufweisen und/oder mit den Polschuhen einteilig oder lösbar verbunden sind.

13. Zerstäubungskathode nach einem oder mehreren der vorhergehenden Ansprüche, **dadurch gekennzeichnet,** daß die negative Spannung an den Polschuhen (23, 24) zwischen Kathodenpotential und Anodenpotential durch einen elektrischen Spannungsteiler (44) anstelle einer zusätzlichen Stromversorgung erzeugt werden kann.

14. Zerstäubungskathode nach einem oder mehreren der vorhergehenden Ansprüche, **dadurch gekennzeichnet,** daß das negative Potential der Polschuhe (23, 24) nach dem Zünden des Plasmas weggenommen werden kann.
